# EUROPEAN PATENT SPECIFICATION

(11) **EP 3 742 244 B1**
(45) Date of publication and mention of the grant of the patent: **11.11.2026**
(21) Application number: 19175510.7
(22) Date of filing: 21.05.2019
(51) Int. Cl.: G05B 19/404, G05B 13/02, G05B 13/04

(54) **A METHOD FOR PREDICTING CHATTER OF A MACHINE TOOL**
VERFAHREN ZUR VORHERSAGE VON RATTERSCHWINGUNGEN EINER WERKZEUGMASCHINE
PROCÉDÉ DE PRÉDICTION DE BROUTEMENT D'UNE MACHINE-OUTIL

(43) Date of publication of application: 25.11.2020
(73) Proprietor: United Machining Mill AG, 2504 Biel/Bienne (CH); Inspire AG, 8005 Zürich (CH)
(72) Inventor: Postel, Martin, 8005 Zürich (CH); Bircan Bugdayci, Nerzat, 8051 Zürich (CH); Monnin, Jérémie, 2562 Port (CH); Besuchet, Jean-Philippe, 2000 Neuchâtel (CH)
(74) Representative: Arend, Christa

(56) References cited:
- EP-A1- 2 916 187
- LIU XIAOLI ET AL: "FNN Approximation-Based Active Dynamic Surface Control for Suppressing Chatter in Micro-Milling With Piezo-Actuators", IEEE TRANSACTIONS ON SYSTEMS, MAN, AND CYBERNETICS: SYSTEMS, IEEE, PISCATAWAY, NJ, USA, vol. 47, no. 8, 1 August 2017 (2017-08-01), pages 2100 - 2113, XP011657012, ISSN: 2168-2216, [retrieved on 20170717], DOI: 10.1109/TSMC.2016.2611579
- KULJANIC E ET AL: "Development of an intelligent multisensor chatter detection system in milling", MECHANICAL SYSTEMS AND SIGNAL PROCESSING, ELSEVIER, AMSTERDAM, NL, vol. 23, no. 5, 1 July 2009 (2009-07-01), pages 1704 - 1718, XP026066572, ISSN: 0888-3270, [retrieved on 20090120], DOI: 10.1016/J.YMSSP.2009.01.003

## Description

### FIELD OF THE INVENTION

The present invention is related to a method for predicting chatter of a machine tool. In further, the present invention is directed to a chatter prediction unit to perform the method.

### BACKGROUND OF THE INVENTION

Chatter is a kind of self-excited vibration and has a crucial impact on the quality of the machined workpiece. If the chatter occurs during the milling process, the quality of the workpiece can be dramatically degraded, for example, the surface quality of the workpiece is poor. Beside this drawback, the lifetime of the cutting tool and/or machine component such as the spindle can be shorted by chatter. Chatter often occurs because of non-optimum combination between machine dynamics and machining parameters. Therefore, if the chatter can be precisely predicted for different machining parameters, tools and workpieces, the optimal machining parameters can be selected in advance to reduce the risk of chatter and thereby improve the quality of the machined workpiece and guarantee the integrity of the machine including cutting tool.

Methods to predict the occurrence of the chatter are well established. However, in the known methods, the accuracy of the prediction is dependent on several parameters; in particular, certain parameters cannot be measured or calculated precisely, since these parameter vary under different machining conditions. Moreover, certain parameters can only be obtained in an experimental environment, which differs from the real production environment. Therefore, systems and methods are proposed to acquire the measurement data in the real production environment to improve the accuracy of the prediction.

EP 2916187 discloses a chatter database system, in which data corresponding to the machining and chatter conditions are acquired from a plurality of machine tools, in particular the data can be obtained while the machine tool machines a workpiece. These data can be used to generate experiment based stability maps, which illustrates the chatter occurrence in relation to the machining parameters. In this system, a large amount of data can be collected from the machine tool in the real production environment. However, this system has still the disadvantage that not all the data required to generate stability maps can be obtained by this way, for example the dynamics of the tool center point.

### SUMMARY OF THE INVENTION

It is an objective of this invention to provide a method and a system to achieve an improved accuracy of chatter prediction for a wide range of machining parameters.

According to the present invention, these objectives are achieved through the features of independent claims, which define the invention. In addition, further advantageous embodiments follow from the dependent claims and the description.

In the present invention, a method for predicting chatter of a machine tool comprises the following steps: feeding first input data into an artificial neural network, which includes a plurality of weights; determining first output data at the output of artificial neural network based on the first input data and the plurality of weights; providing the first output data and second input data into a stability model to generate prediction data; and comparing the prediction data with measured stability data and adjusting the plurality of weights of the artificial neural network. The stability model input comprises the second input data and the first output data from the output of the artificial neural network.

Different models are available to predict the stability conditions. Examples are the analytical Zero Order Solution or the time-domain based semi-discretization method and the full discretization method. The references related to the different models and chatter are:
- Budak E, Altintas Y (1998) Analytical Prediction of Chatter Stability in Milling-Part I: General Formulation. Journal of Dynamic Systems, Measurement, and Control, 120(1): p. 22-30.
- Insperger T, Stépán G (2002) Semi-discretization method for delayed systems. International Journal for Nu-merical Methods in Engineering, 55(5): p. 503-518.
- Ye Ding, LiMin Zhu, XiaoJian Zhang, Han Ding, A full-discretization method for prediction of milling stability, International Journal of Machine Tools and Manufacture, Volume 50, Issue 5, 2010, Pages 502-509,
- J. Munoa, X. Beudaert, Z. Dombovari, et al., Chatter suppression techniques in metal cutting, CIRP Ann. Manuf. Technol. 65 (2) (2016) 785-808.

For computation reasons, it is advantageous to use the Zero Order Solution model as stability model to calculate the stability limit. But the method of the present invention is not limited to this stability model and any stability model can be used.

Stability lobe diagrams are a well-known visual illustration to distinguish stable from unstable machining parameters in milling operations. In the stability lobe diagram, the stability limit is depicted e.g. in terms of critical depth of cut in function of the spindle speed.

One method to create stability lobe diagrams is to establish a stability model and use this model to obtain the stability lobe diagrams. This model-based approach requires information about the structural parameters, e.g. relative dynamics in the tool-workpiece contact zone, and about the process parameters, such as the cutting force coefficients that relate the chip thickness with resulting forces. In order to determine the dynamics of the machine tool and cutting force coefficients, extensive measurements are mandatory. Such measurements cause additional costs. In further the measurement cannot be conducted during the production, therefore, the measurement condition does not correspond to the real machining condition. Since the machine dynamics may change significantly under the real machining condition, the accuracy of the measurement is not satisfied. Consequently, the stability lobe diagram established based on the inaccurate data does not provide sufficient accuracy, in particular in the application of high-precision milling machine tool. The method of the present invention enables that the data required for the stability lobe diagram can be derived with higher precision.

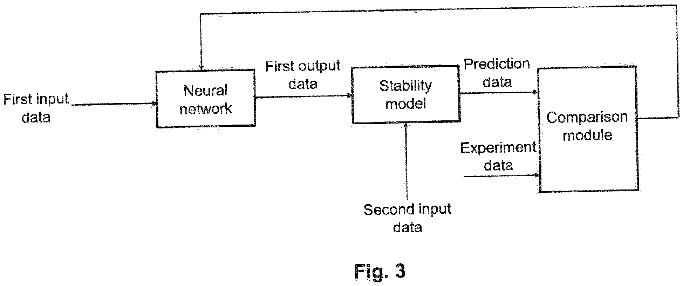

For some given machining conditions, the stability model can be applied to predict the occurrence of the chatter and the corresponding chatter frequency, which defines the frequency of the vibration between the tool and the workpiece. This represents the prediction data depicted in figure 3. The stability model requires several input parameters to make a chatter prediction. Some of these are reliably known and some others might be uncertain. In the following, the uncertain parameters are called first output data and the known parameters are called second input data. At the beginning, it is necessary to define which parameters are uncertain and if such parameters are dependent on other known parameters. This enables to define the so-called first input data. The first input data and the second input data are both known parameters, but they represent different types of parameters. The first output data describe parameters that are estimated based on the first input data.

The first input data represent known parameters susceptible to influence the uncertain input parameters of the stability model, i.e. the first output data. The first input data can be either machining parameters set by the machine-tool operator, e.g. spindle speed, feed rate, depths of cut, lubrication conditions, workpiece material, or machining parameters measured during the machining, such as the spindle bearing temperature, axis loads.

The second input data are parameters which are known with a sufficiently high degree of precision like the number of flutes of a tool or the cutter engagement, such as entry and exit angle. If reliably known, it is also possible to directly specify parameters related to machine dynamics or cutting force interaction as second input data, like for example, the modal parameters of Tool Center Point or cutting force coefficients.

The parameters required as input of the stability model are defined by the type of the stability model used. If the parameter is precisely known, it is as the second input data directly fed into the stability model. If the parameter is unknown or its dependency to other known parameters is uncertain, this parameter is derived from the neural network. For example, entry and exit angles or the number of flutes are typically second input data. However, the modal parameters defining the machine dynamics or the cutting force coefficients can be second input data or the first output data depending on how accurate and reliable their values are known.

In order to determine the functional relationship between the first input data and the first output data, an artificial neural network is implemented upstream of the stability model. The artificial neural network is trained by comparing the prediction data generated by the stability model with experiment data, which result from real cutting process at corresponding machining conditions. The effective stability of the cutting process is monitored using a chatter detection system, which identifies during machining if a chatter phenomenon occurs and output the chatter frequency, if the chatter is detected. This collected information constitutes the experiment data and must be related to the corresponding machining conditions. Thus, the learning process of the artificial neural network does not explicitly require dedicated tests but can be done during production conditions. Also, arbitrary interactions between parameters can be identified, e.g. modal parameters that depend on spindle speed and load condition.

The artificial neural network generally includes one input layer with *I* inputs, one hidden layer with N nodes and one output layer with 0 outputs. The input and the hidden layer are connected with weights *w*_{*h*_{*j*,*k*}} which multiply the respective input *iⱼ* (*j* = 1 ... *I*) and pass it to node *nₖ* (*k =* 1 ... *N*). At each node, the sum of all inputs multiplied with the respective weights is transformed with an activation function *aₖ*. The results are multiplied with the weights *w*_{*o*_{*k*,*l*}} and summed to obtain the desired outputs *oₗ* (*l* = 1*... O*). The hidden and output layer also have bias terms *b_{hₖ}* and *b_{oₗ}* which are constants added to the respective layer. In the most simple case where constant parameters are assumed, the network reduces to the output bias values *b_{oₗ}*.

In the present invention, the first output data *oₗ* in the output layer become the inputs of the stability model. One challenge is to choose the number of nodes suitable for a specific application. In one variant, this number is therefore chosen to be a hyperparameter, which is iterated over during the training.

For a given first output data, the stability model yields the prediction data including stability limit *a_{p_{pred}}* and the associated chatter frequency *f_{c_{pred}}.* The prediction data is then compared with the experiment data to adjust the weights of the neural network. The goal is to tune the weights in the artificial neural network such that any combination of network inputs yields such stability model inputs that the predicted process stability and chatter frequencies are in agreement with the experiment data.

Depending on the applications, the appropriate training algorithm must be chosen. The most common learning algorithm for a simple feedforward neural network is backpropagation. Backpropagation describes a technique where the error between output and target values is calculated and backpropagated through the network to adjust the weights in the network. This technique, however, requires all operations in the network structure to be differentiable. In this work, the Zero Order Solution (ZOS) is used as a stability model. Since the ZOS includes non-differentiable operations and the error term is only calculated downstream of the stability model, backpropagating the error is not possible. Hence, a different training algorithm needs to be applied. In the present invention, the neural network is trained with an evolutionary algorithm. This means, the weights and bias terms of the neural network are adjusted by using an evolutionary algorithm. In a preferred embodiment, the neural network is trained with a genetic algorithm. The algorithm is initialized by the creation of a population of individuals. Each individual consists of several genes, which represent the variables of the problem. All of the genes together therefore constitute one possible solution for the problem under consideration. The fitness of each individual is evaluated with a defined objective function. Individuals with high fitness values are then selected for performing genetic operations of crossover and mutation.

In one embodiment, each individual in the population represents one possible solution for the weights and biases of the networks. For each measurement sample, the first input data are fed into the networks and the first output data are calculated using the weights encoded in the respective individual. The network output is fed into the stability model along with the second input data and the prediction data including stability limit and chatter frequency are calculated for each sample. After comparison of the predicted and the measured stability data, namely the prediction data and the experiment data, the weights and the bias of the neural network can be tuned until the deviation of the prediction data and the measurement stability data is below a defined value.

In some embodiments, the derived relationships between the first input data and first output data can be used for other models than a stability model as well. For example, identified relationships between spindle speed and the modal parameters defining the machine dynamics can serve as inputs to a spindle speed dependent tool displacement prediction model. The modal parameters include for instance the natural frequencies and damping ratios.

As outlined above, it is essential to use the data obtained in a real production environment to guarantee the accuracy of the prediction. Therefore, the first input data and/or the second input data and/or the experiment data is at least a part of the collected data, which may be acquired when the machine tool machines a workpiece. Using the experiment data measured during the machining improves the accuracy of the prediction. The collected data include not only the experiment data but also the machining parameters set by the operator, such as axes position, axes feed direction, depth of cut, spindle speed and workpiece parameters, or the measured machining parameters such as temperature of the spindle and load of axis.

In the training process of artificial neural networks, overfitting to the presented data set can be a concern. Overfitting describes the state when a network performs very well on the data used for training but performs poorly on data it has never seen. In other words, the resulting model will not generalize well to new data, which is one of the key ideas of artificial neural network. In order to reduce the risk of overfitting, the method can be further optimized by dividing the collected data into a training set and a validation set to verify the trained data. In one variant, the collected data is split into a training and a validation data set, for example containing around 70% and 30% of the total data respectively. The idea is to perform weight tuning until the validation error starts increasing while the training error continues decreasing. This behaviour may be a hint that overfitting is occurring.

In a preferred variant, at least a second artificial neural network is connected to the stability model to feed the output data of the second neural network into the stability model.

In particular, if required, further neural networks can be connected into the stability models. The number of the neural networks to be applied is application dependent but is not limited to 2. The two independent neural networks connected to the stability model have each their own structure with a specific number of nodes and network input and output layer. Creating multiple neural networks instead of combining all input and output parameters into one neural network can be advantageous if no interaction between the input parameters is expected. This leads to increased identification speed and avoids the inclusion of physically nonsense solutions. For example, there can be one network to identify feed dependent cutting force coefficients and another one to identify TCP dynamics as a function of spindle speed and position in the workspace.

In the present invention, a processing unit is configured to perform the method of the present invention and comprises a neural network module, a stability model module and a comparison module.

Preferably, the chatter prediction unit is further configured to establish the stability map. If the chatter prediction unit is located in a central system, which can be accessed by different machine tools, the stability maps generated can be centralized and is easily made accessible for the machine tools. The collected data are advantageously obtained during the machining of the workpiece. For this purpose, a machine tool comprises a sensing unit to obtain the experiment data. Moreover, the machine tool includes a communication unit configured to send the experiment data and the machining parameters set by the operator to the chatter prediction unit and using the stability maps generated by chatter prediction unit to select the machining parameters to machine the workpiece.

In the present invention, a system includes a plurality of machine tools and a chatter prediction unit.

### BRIEF DESCRIPTION OF THE DRAWINGS

In order to describe the manner in which advantages and features of the disclosure can be obtained, in the following a more particular description of the principles briefly described above will be rendered by reference to specific embodiments thereof which are illustrated in the appended drawings. These drawings depict only exemplary embodiments of the disclosure and are not therefore to be considered to be limiting of its scope. The principles of the disclosure are described and explained with additional specificity and detail through the use of the accompanying drawings in which:
- Fig. 1: illustrates the method of the present invention;
- Fig. 2: illustrates artificial neural network;
- Fig. 3: illustrates a first embodiment of the present invention;
- Fig. 4: illustrates a second embodiment of the present invention;
- Fig. 5: illustrates a simulated result of the second embodiment;
- Fig. 6: illustrates a third embodiment of the present invention;
- Fig. 7: illustrates a measurement result of the third embodiment;
- Fig. 8: illustrates a system of the present invention.

### EXEMPLARY EMBODIMENTS

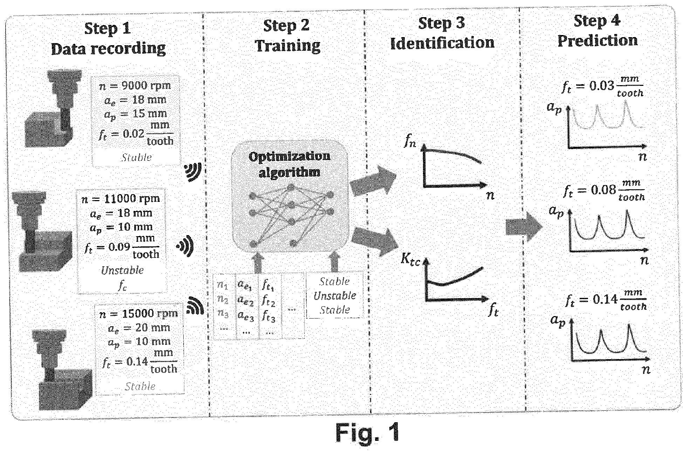

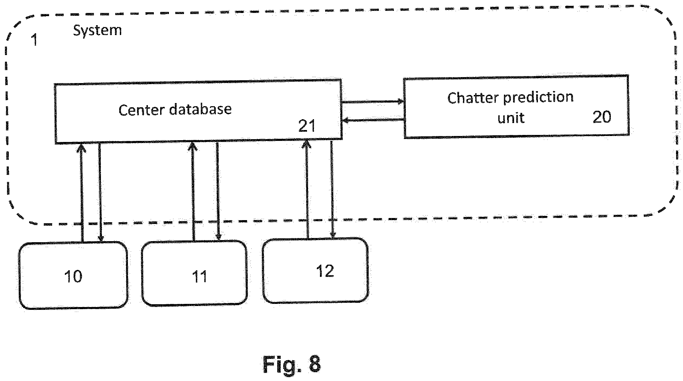

The present invention presents a method for chatter prediction. In particular, the method aims to identify unknown stability model input parameters required to calculate the stability boundary in milling operations. The main steps of the method are shown in figure 1. In step 1, during machining a workpiece, the collected data including current machining parameters and experiment data of the respective machining are continuously recorded. The collected data can be stored in a center database of a chatter prediction unit 1 shown in figure 8. In steps 2 and 3, a part of the collected data is fed into an artificial neural network to identify the unknown parameters required to generate stability maps using a stability model. One condition for the identification of the unknown parameters is that the best possible agreement between model stability predictions and measurement results is obtained. To achieve this, a comparison module is provided to compare prediction data and the experiment data. The deviation of these data is used to train the neural network such that the deviation is optimized to a defined threshold value. In step 4, after the unknown parameters are identified, stability maps can be generated using the identified parameters. In further, with the identified parameters and relationships, stability predictions for new parameter combinations are possible.

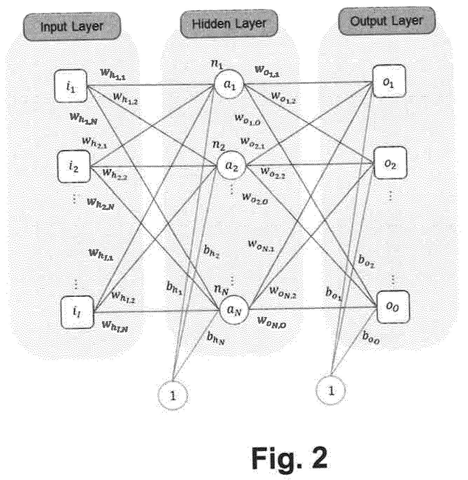

Figure 2 shows a basic structure of a neural network with one input layer having *I* inputs, one hidden layer having N nodes and one output layer having 0 outputs. The input and the hidden layer are connected with weights *w_{h_{j,k}}* which multiply the respective input *iⱼ* (*j =* 1 ... *I*) and pass it to node *nₖ* (*k* = 1 ... *N*). At each node, the sum of all inputs multiplied with the respective weights is transformed with an activation function *aₖ*. The results are multiplied with the weights *w_{o_{k,l}}* and summed to obtain the desired outputs *oₗ* (*l* = 1 ... *O*). The hidden and output layer also have bias terms *b_{hₖ}* and *b_{oₗ}* which are constants added to the respective layer.

Figure 3 illustrates a first embodiment of the present invention. First input data is fed into the neural network. First output data can be calculated based on the weighs and bias terms of the neural network. The calculated first output data is then fed into a stability model to obtain prediction data. A comparison module is provided and configured to compare the prediction data and the experiment data for the same cutting spindle speed and depth of cut. The output of comparison module is fed back to the neural network to train the neural network. The training means adjusting the weights and the bias terms of the neural network to achieve a minimum of the deviation between the prediction data and the experiment data. In this embodiment, besides the first output data set, second input data is fed into the stability model. The stability is calculated based on the Zero Order Solution. The stability model yields the prediction data including stability limit and the associated chatter frequency. The first input data comprises machining parameters for example, spindle speed, spindle bearing temperature. The second input data comprises parameters that are known to a high precision and can directly be fed into the stability model, for example the entry and exit angle. The prediction data is then compared with the actual stability state of the experiment, namely the experiment data.

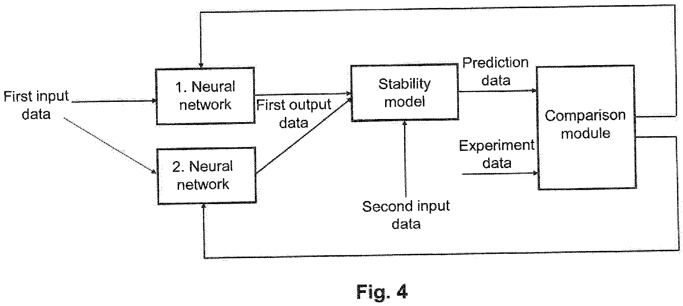

Figure 4 illustrates a second embodiment of the present invention. In this embodiment, two neural networks are applied and the first input data is divided into two groups and fed into the two neural networks, respectively. The first neural network is applied to identify the feed dependent cutting force coefficients while the second neural network aims to identify the TCP dynamics, the modal parameters. The input of the first neural network is therefore the feed rate and the workpiece material. A neural network having two output nodes is chosen which defines the cutting force coefficients. The input of the second neural network is spindle speed and the machining temperature. The second neural network has also two output nodes defining the modal parameters, which are natural frequency and damping. In this embodiment, the first output data encompasses the output of the first neural network and the second neural network.

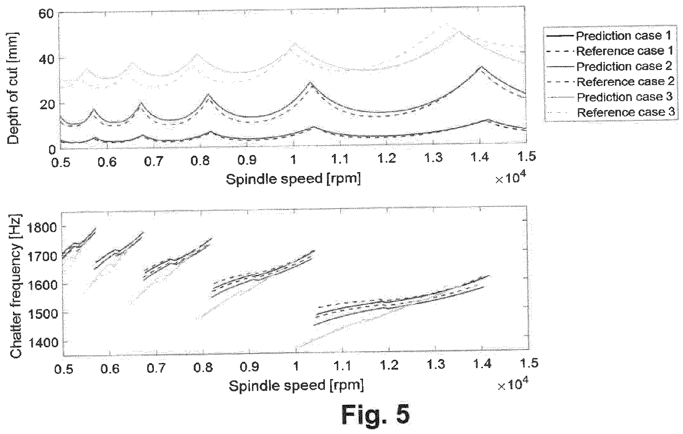

Figure 5 shows a simulative result of the embodiment of figure 4, in which four parameters are influenced by another four parameters. Without prior knowledge about the behaviour of the stability model inputs the underlying relationships are identified from the results of 50 simulative cuts. It is assumed that the dynamics of a given machine-spindle-tool combination show a strong dependency on the spindle speed and the spindle bearing temperature. A three fluted cutter is used for cuts in two different work piece materials (workpiece 1 and workpiece 2). These cuts are performed in both X- and Y-direction of the machine tool at different feed rates, spindle speeds and depths of cut. The following assumptions about the unknown parameters are made:
(1) Natural frequency *f*ₙ and damping ratio ξₙ are dependent on spindle speed n and spindle bearing temperature T;
(2) TCP dynamics are equal in X- and Y-direction; and
(3) Cutting force coefficients *K*_{tc} and *K*_{rc} depend on nominal feed rate *f*ₜ and workpiece material WP.

Mathematically, these assumptions can be expressed as follows: ${f}_{{n}_{x}} = {f}_{{n}_{y}} = {f}_{n} = f \left(n, T\right) , {ξ}_{{n}_{x}} = {ξ}_{{n}_{y}} = {ξ}_{n} = f \left(n, T\right)$ ${K}_{tc} = f \left({f}_{t}, WP\right) , {K}_{rc} = f \left({f}_{t}, WP\right)$ where *K*_{*tc*₁}*, K*_{*rc*₁} and *K*_{*tc*₂}*, K*_{*rc*₂} are the tangential and radial cutting force coefficients of workpiece 1 and 2, respectively, and *fₙ* and *ξₙ* are the natural frequency and damping ratio, respectively. The stability of 50 different cuts is evaluated in simulations. For each simulation, the spindle speed, bearing temperature, entry and exit angle, feed per tooth as well as the direction of cut and workpiece type are sampled randomly in a defined range. The depth of cut for each simulative sample is chosen with respect to the theoretical stability limit as follows: *aₛᵢₘ* = (1 *+ x*) · *a_{theoretical},* where *x* is a random number uniformly drawn from the range -0.3 to 0.3. This approach corresponds to the idea that cuts are performed with up to 30% deviation from the theoretical stability limit with the same chance that a cut is performed above and below the theoretical boundary, respectively. The possibility to include such cuts away from the stability limit in the inverse identification is an important advantage of the present invention.

In order to identify the first output data of the neural network, the first input data is split into a training and a validation data set, containing 70% and 30% of the data, respectively. The optimization is run for a maximum of 250 generations, each with a population size, i.e. number of individuals, of 250. The number of nodes N and the weight and bias limit |*wₘₐₓ*| are chosen as hyperparameters. The number of nodes are iterated over in a range between *N* = 2 and *N* = 8 while the maximum weight is evaluated between |*wₘₐₓ*| = 0.1 and |*wₘₐₓ*| = 10 in 25 steps with logarithmic spacing.

The goal is now to identify a relationship between the inputs n and T and the outputs fₙ and ξ*ₙ*, as well as the inputs fₜ and workpiece material WP and the outputs K_{tc} and K_{rc} using the neural network. Network outputs are used to calculate speed dependent stability maps. The predicted stability limits are plotted against the theoretical ones in figure 5. For cases 1 and 2, a very good agreement of predicted and actual stability chart can be observed. The case 3 yields a less good prediction. In this case, the temperature is T=50 degC, which is exactly the upper limit of the distribution the random samples were drawn from.

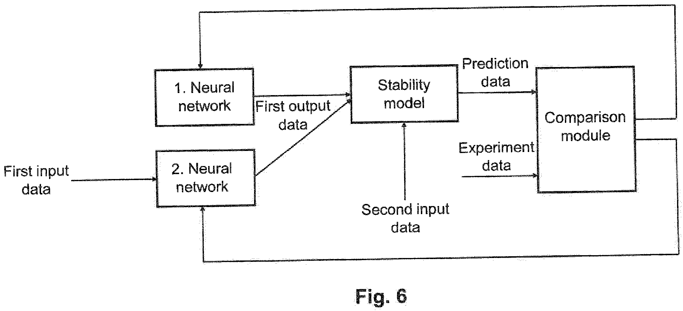

Figure 6 illustrates a third embodiment, in which two neural networks are applied. The first input data however is only fed into one neural network. The first neural network is applied to estimate the TCP dynamics while the second network is used to identify the cutting force coefficients depending on feed and spindle speed. The first output data includes the output of the first neural network and the second neural network. Since no input data are present in the first neural network, the neural network is defined only by bias terms and the output, e.g. natural frequency, damping ratio.

For this embodiment, an experimental study is conducted to verify the approach with real cutting data. A two fluted 12 mm diameter end mill is mounted to a shrink fit holder with 64 mm stick-out length. The holder is clamped to a Mikron high-performance five-axis milling machine and slotting experiments are performed in Aluminum 7075 with feed rates of 0.03 mm/tooth, 0.05 mm/tooth and 0.12 mm/tooth.

Measurement data is acquired by performing 40 cuts (21 stable and 19 unstable) at arbitrary spindle speeds between 7000 rpm and 13000 rpm and depths of cut between 1.3 mm and 2.5 mm. Since the dominant mode is expected to be a mode of the tool-holder combination and a shrink fit holder is used, no dependency of the dynamics on the spindle speed is assumed. Besides the convenience of this approach in identifying dynamic parameters, it was also shown that this method can yield more precise results compared to regular impact testing if a thin tool is considered. On the other hand, it is well known that cutting force coefficients obtained from mechanistic calibration might be significantly different at different nominal feed rates and spindle speeds. Hence, K_{tc} and K_{rc} are set as functions of the spindle speed and feed rate.

Two separate networks are created. One has the purpose to identify the modal parameters and the other one the cutting force coefficients as a function of the feed rate and spindle speed. Since no input parameters are present in the first network, it is reduced to the bias terms bₒₗ⁽¹⁾,I=1...4. For the second network, one hidden layer with two nodes is used for the approximation of the relationship between spindle speed and feed rate and cutting force coefficients. The data set is randomly split into a training and a validation set containing 28 and 12 samples, respectively. A population of 100 individuals is used, and the optimization is stopped after 150 generations. The optimization process is run for different values of |wₘₐₓ| in a range between 0.3 and 1.1. The lowest validation error is obtained for |wₘₐₓ|=0.7.

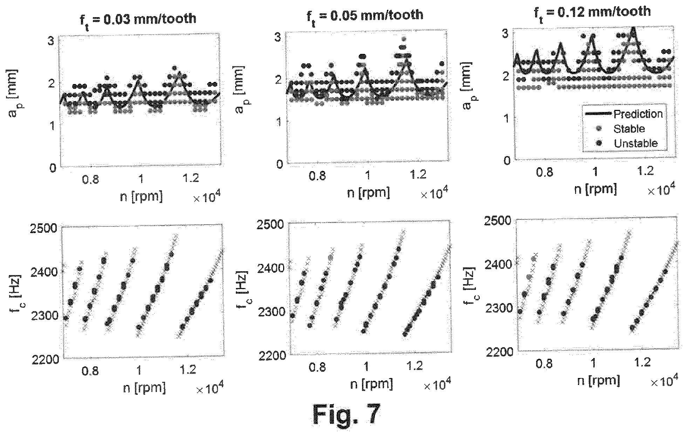

In a next step, speed- and feed-dependent stability lobes are constructed with the identified network parameters. The results are shown in figure 7. Overall, good predictions are obtained for the three feed rates of interest. The trend of an increasing stability limit with increasing feed rate can be well predicted, and the pocket locations are well matched. However, for the highest feed rate, the unconditional limit depth of cut is overestimated by approximately 15%.

Figure 8 shows a system 1 comprising a chatter prediction unit 20, a center database 21 and three machine tools 10, 11 and 12. The number of the machine tools is just an illustration of including a plurality of machine tools and is therefore not limited to three. The experiment data is obtained by the machine tools and sent to the center database to be stored. The chatter prediction unit inquires the collected data needed from the center database to establish the stability maps. The established stability maps are stored in the center database and are accessible for the machine tools.

### LIST OF REFERENCES

- 1: system
- 10: machine tool
- 11: machine tool
- 12: machine tool
- 20: chatter prediction unit
- 21: center database

## Claims

1. A method for predicting chatter of a machine tool being occurred during machining a workpiece by the machine tool by a chatter prediction unit comprising:
- feeding first input data into an artificial neural network, which includes a plurality of weights, wherein the first input data are a first type of known machining parameters applied to machine a workpiece by a machine tool and known machining parameters are machining parameters set by a machine-tool operator or machining parameters measured during machining;
- determining first output data at the output of the artificial neural network based on the first input data and the plurality of weights, wherein the first input data represent known parameters influencing the uncertain input parameters of the stability model and the first output data represent uncertain parameters required as input data for a stability model;
- providing the first output data and second input data into the stability model for predicting the occurrence of the chatter and the corresponding chatter frequency, which defines the frequency of vibration between the tool and the workpiece to generate prediction data including the occurrence of the chatter and the corresponding chatter frequency, wherein the second input data represents a second type of known machining parameters required as input data for the stability model, wherein the first input data and/or the second input data and/or experiment data is at least a part of the collected data, which may be acquired when the machine tool machines a workpiece;
- comparing the prediction data with experiment data by a comparison module and adjusting the plurality of weights, wherein an evolutionary algorithm is applied for tuning the weights of the artificial neural network, wherein the artificial neural network is trained by comparing the prediction data generated by the stability model with experiment data, which result from real cutting process at corresponding machining conditions.

2. The method according to claim 1, wherein the method further includes obtaining collected data from at least one machine tool when the machine tool machines the workpiece, in particular the collected data include experiment data, machining parameters set by the operator and machining parameters measured during machining.

3. The method according to claim 2, wherein a part of the first input data and/or the second input data are derived from the collected data.

4. The method according claim 2 or 3, wherein the collected data are divided into a training set and a validation set, and the evolutionary algorithm trains the neural network with the training set and verifies the accuracy of the trained neural network with the validation set.

5. A chatter prediction unit is configured to perform the method according to one of claims 1 to 4 comprising a neural network module, a stability model module and a comparison module.

6. The chatter prediction unit according to claim 5, is further configured to establish the stability map.

7. A system including a plurality of machine tools and the chatter prediction unit according to claim 5, wherein the machine tool:
a. includes a sensing unit configured to obtain the experiment data;
b. includes a communication unit configured to send the collected data, including the experiment data, to a center database connected to the chatter prediction unit; and
c. is configured to use the stability maps generated by the chatter prediction unit to determine the machining parameters to machine the workpiece.

## Patentansprüche

1. Verfahren zur Vorhersage von Ratterschwingungen einer Werkzeugmaschine, die während der Bearbeitung eines Werkstücks durch die Werkzeugmaschine auftreten, durch eine Einheit zur Vorhersage von Ratterschwingungen, umfassend:
- Einspeisen erster Eingabedaten in ein künstliches neuronales Netzwerk, das eine Vielzahl von Gewichtungen umfasst, wobei die ersten Eingabedaten einen ersten Typ bekannter Bearbeitungsparameter darstellen, die zum Bearbeiten eines Werkstücks durch eine Werkzeugmaschine angewendet werden, und wobei die bekannten Bearbeitungsparameter Bearbeitungsparameter sind, die von einem Bediener der Werkzeugmaschine eingestellt werden, oder Bearbeitungsparameter, die während der Bearbeitung gemessen werden;
- Bestimmen erster Ausgabedaten am Ausgang des künstlichen neuronalen Netzwerks basierend auf den ersten Eingabedaten und der Vielzahl von Gewichtungen, wobei die ersten Eingabedaten bekannte Parameter darstellen, welche die unsicheren Eingabeparameter des Stabilitätsmodells beeinflussen, und wobei die ersten Ausgabedaten unsichere Parameter darstellen, die als Eingabedaten für ein Stabilitätsmodell erforderlich sind;
- Bereitstellen der ersten Ausgabedaten und zweiter Eingabedaten für das Stabilitätsmodell zur Vorhersage des Auftretens der Ratterschwingungen und der zugehörigen Ratterfrequenz, welche die Frequenz der Schwingung zwischen dem Werkzeug und dem Werkstück definiert, um Vorhersagedaten zu erzeugen, die das Auftreten der Ratterschwingungen und die zugehörige Ratterfrequenz umfassen, wobei die zweiten Eingabedaten einen zweiten Typ bekannter Bearbeitungsparameter darstellen, die als Eingabedaten für das Stabilitätsmodell erforderlich sind, und wobei die ersten Eingabedaten und/oder die zweiten Eingabedaten und/oder Versuchsdaten zumindest einen Teil der erfassten Daten darstellen, die erfasst werden können, während die Werkzeugmaschine ein Werkstück bearbeitet;
- Vergleichen der Vorhersagedaten mit Versuchsdaten durch ein Vergleichsmodul und Anpassen der Vielzahl von Gewichtungen, wobei ein evolutionärer Algorithmus zum Abstimmen der Gewichtungen des künstlichen neuronalen Netzwerks angewendet wird, und wobei das künstliche neuronale Netzwerk durch Vergleichen der von dem Stabilitätsmodell erzeugten Vorhersagedaten mit Versuchsdaten trainiert wird, die aus einem realen Schnittprozess unter entsprechenden Bearbeitungsbedingungen resultieren.

2. Verfahren nach Anspruch 1, wobei das Verfahren ferner das Erhalten erfasster Daten von mindestens einer Werkzeugmaschine umfasst, während die Werkzeugmaschine das Werkstück bearbeitet, wobei die erfassten Daten insbesondere Versuchsdaten, von dem Bediener eingestellte Bearbeitungsparameter und während der Bearbeitung gemessene Bearbeitungsparameter beinhalten.

3. Verfahren nach Anspruch 2, wobei ein Teil der ersten Eingabedaten und/oder der zweiten Eingabedaten aus den erfassten Daten abgeleitet wird.

4. Verfahren nach Anspruch 2 oder 3, wobei die erfassten Daten in einen Trainingsdatensatz und einen Validierungsdatensatz unterteilt werden und der evolutionäre Algorithmus das neuronale Netzwerk unter Verwendung des Trainingsdatensatzes trainiert und die Genauigkeit des trainierten neuronalen Netzwerks unter Verwendung des Validierungsdatensatzes verifiziert.

5. Einheit zur Vorhersage von Ratterschwingungen, die dazu konfiguriert ist, das Verfahren nach einem der Ansprüche 1 bis 4 durchzuführen, wobei die Einheit ein neuronales Netzwerkmodul, ein Stabilitätsmodellmodul und ein Vergleichsmodul umfasst.

6. Einheit zur Vorhersage von Ratterschwingungen nach Anspruch 5, die ferner dazu konfiguriert ist, die Stabilitätskarte zu erstellen.

7. System, das eine Vielzahl von Werkzeugmaschinen und die Einheit zur Vorhersage von Ratterschwingungen nach Anspruch 5 beinhaltet, wobei die Werkzeugmaschine:
a. eine Sensoreinheit beinhaltet, die dazu konfiguriert ist, die Versuchsdaten zu erhalten;
b. eine Kommunikationseinheit beinhaltet, die dazu konfiguriert ist, die erfassten Daten, die die Versuchsdaten beinhalten, an eine mit der Einheit zur Vorhersage von Ratterschwingungen verbundene zentrale Datenbank zu senden; und
c. dazu konfiguriert ist, die von der Einheit zur Vorhersage von Ratterschwingungen erzeugten Stabilitätskarten zu verwenden, um die Bearbeitungsparameter zum Bearbeiten des Werkstücks zu bestimmen.

## Revendications

1. Procédé de prédiction du broutement d'une machine-outil survenant lors de l'usinage d'une pièce par la machine-outil par une unité de prédiction du broutement, le procédé comprenant les étapes suivantes :
- alimenter, avec des premières données d'entrée, un réseau de neurones artificiels qui comporte une pluralité de poids, où les premières données d'entrée sont un premier type de paramètres d'usinage connus appliqués pour usiner une pièce par une machine-outil, et les paramètres d'usinage connus sont des paramètres d'usinage déterminés par un opérateur de machine-outil ou des paramètres d'usinage mesurés pendant l'usinage ;
- déterminer des premières données de sortie en sortie du réseau de neurones artificiels à partir des premières données d'entrée et de la pluralité de poids, où les premières données d'entrée représentent des paramètres connus influençant les paramètres d'entrée incertains du modèle de stabilité et les premières données de sortie représentent des paramètres incertains requis comme données d'entrée pour un modèle de stabilité ;
- fournir les premières données de sortie et les deuxièmes données d'entrée dans le modèle de stabilité pour prédire l'occurrence du broutement et la fréquence de broutement correspondante, qui définit la fréquence de vibration entre l'outil et la pièce pour générer des données de prédiction, y compris l'occurrence du broutement et la fréquence de broutement correspondante, les deuxièmes données d'entrée représentant un deuxième type de paramètres d'usinage connus requis comme données d'entrée pour le modèle de stabilité, les premières données d'entrée et/ou les deuxièmes données d'entrée et/ou les données expérimentales constituant au moins une partie des données collectées, qui peuvent être acquises lors de l'usinage d'une pièce par la machine-outil ;
- comparer les données de prédiction aux données expérimentales au moyen d'un module de comparaison et ajuster la pluralité de poids, où un algorithme évolutif est appliqué pour ajuster les poids du réseau de neurones artificiels, où le réseau de neurones artificiels est entraîné en comparant les données de prédiction générées par le modèle de stabilité aux données expérimentales, qui résultent d'un processus réel de coupe dans des conditions d'usinage correspondantes.

2. Procédé selon la revendication 1, dans lequel le procédé comprend en outre d'obtenir des données collectées à partir d'au moins une machine-outil lorsque la machine-outil usine la pièce à usiner, en particulier les données collectées comprennent des données expérimentales, des paramètres d'usinage définis par l'opérateur et des paramètres d'usinage mesurés pendant l'usinage.

3. Procédé selon la revendication 2, dans lequel une partie des premières données d'entrée et/ou des deuxièmes données d'entrée sont dérivées des données collectées.

4. Procédé selon la revendication 2 ou la revendication 3, dans lequel les données collectées sont divisées en un ensemble d'apprentissage et un ensemble de validation, et l'algorithme évolutif entraîne le réseau neuronal avec l'ensemble d'apprentissage et vérifie la précision du réseau neuronal entraîné avec l'ensemble de validation.

5. Unité de prédiction du broutement configurée pour mettre en œuvre le procédé selon l'une des revendications 1 à 4, comprenant un module de réseau de neurones, un module de modèle de stabilité et un module de comparaison.

6. Unité de prédiction du broutement selon la revendication 5, en outre configurée pour établir la carte de stabilité.

7. Système comprenant une pluralité de machines-outils et l'unité de prédiction du broutement selon la revendication 5, dans lequel la machine-outil :
a. comporte une unité de détection configurée pour obtenir les données expérimentales ;
b. comporte une unité de communication configurée pour envoyer les données collectées, y compris les données expérimentales, à une base de données centrale connectée à l'unité de prédiction du broutement ; et
c. est configurée pour utiliser les cartes de stabilité générées par l'unité de prédiction du broutement afin de déterminer les paramètres d'usinage pour usiner la pièce.
